# EUROPÄISCHE PATENTSCHRIFT

(11) **EP 1 197 758 B1**
(45) Veröffentlichungstag und Bekanntmachung des Hinweises auf die Patenterteilung: **30.11.2005**
(21) Anmeldenummer: 01122715.4
(22) Anmeldetag: 21.09.2001
(51) Int. Cl.: G01R 31/3185

(54) **Integrierter Halbleiterbaustein mit überbrückbarem Eingangs-Tiefpassfilter**
Semiconductor integrated device with shuntable low pass filter at its inputs
Circuit intégré semiconducteur muni d'un filtre passe bas shuntable à l'entrée

(30) Priorität: 14.10.2000 DE 10051100
(43) Veröffentlichungstag der Anmeldung: 17.04.2002
(73) Patentinhaber: Infineon Technologies AG, 81669 München (DE)
(72) Erfinder: Rautmann, Dirk, 84419 Schwindegg (DE)
(74) Vertreter: Patentanwälte Westphal, Mussgnug & Partner

(56) Entgegenhaltungen:
- EP-A- 0 454 320
- DE-A- 3 821 230
- US-A- 4 523 312
- US-A- 4 779 273

## Beschreibung

Die vorliegende Erfindung betrifft einen integrierten Halbleiterbaustein gemäß den Merkmalen des Oberbegriffs des Anspruchs 1.

Um eine Kommunikation zwischen mehreren integrierten Halbleiterbausteinen (IC) zu ermöglichen oder um einen integrierten Halbleiterbaustein anzusteuern ist es bekannt, die Halbleiterbausteine oder Halbeiterbausteine und eine Ansteuereinheit an einen gemeinsamen Datenbus anzuschließen, über welchen der Datenverkehr erfolgt. Bei sogenannten Consumer-ICs, die in Gegenständen des täglich Lebens, wie Haushaltsgeräten oder Geräten der Unterhaltungselektronik eingesetzt werden, hat sich in den letzten Jahren der sogenannte IIC-Bus zum Datenaustausch zwischen integrierten Halbleiterbausteinen durchgesetzt. Der IIC-Bus ermöglicht einen standardisierten Datenverkehr zwischen den einzelnen Bausteinen, wobei in jedem der Bausteine eine geeignete Schnittstellenschaltung vorgesehen ist, welche das IIC-Protokoll unterstützt und welche den Datenverkehr über den Bus abwickelt.

Ein wesentlicher Schritt bei der Herstellung von integrierten Halbleiterbausteinen ist der Test des hergestellten Bausteine IC auf Fehlerfreiheit. Dabei werden möglichst viele oder alle Einstellungen, die in der integrierten Schaltung möglich sind vorgenommen und überprüft. Der Test des IC soll dabei möglichst wenig Zeit in Anspruch nehmen. Um Tests an einem IC durchführen zu können sind zusätzliche Schaltungsmaßnahmen in dem IC erforderlich. Der Aufwand für diese Schaltungsmaßnahmen soll zudem möglichst gering gehalten werden, das heißt die zusätzlichen Schaltungsmaßnahmen, die üblicherweise nur einmal während der Lebensdauer des IC benötigt werden, sollen möglichst wenig der zur Verfügung stehenden Chipfläche verbrauchen.

Außerdem ist es angestrebt für den Test nur die ohnehin benötigten Anschlusspins des IC zu verwenden und keine zusätzlichen Anschlusspins zu Testzwecken vorzusehen.

Die EP 0 454 320 A1 beschreibt ein Verfahren zum Testen von Schaltungsmodulen, die unterschiedliche Systemtakte aufweisen. Bei diesem Verfahren ist vorgesehen, die Systemtakte zu Testzwecken zu deaktivieren und allen Modulen während des Tests ein gemeinsames Master-Taktsignal vorzugeben, wodurch während des Tests ein aufwendiges Synchronisieren der einzelnen Systemtakte vermieden werden kann.

Die US 4,779,273 beschreibt eine Anordnung für einen Selbsttest von Logiknetzwerken. Hierbei ist vorgesehen, ein in einem Register gespeichertes Testmuster an Eingänge des Netzwerks anzulegen und die an Ausgängen des Netzwerks als Reaktion auf das Testmuster anliegenden Signale in dem Register abzuspeichern und auszuwerten.

Ein weiteres Verfahren und eine weitere Vorrichtung zum Testen von Logikschaltungen ist in der US 5,173,904 beschrieben.

Die Verwendung des IIC-Bus für die Vornahme von Einstellungen an dem IC während des Tests ist bislang ungünstig, weil die Bandbreite für den Datenaustausch über den IIC-Bus mittels eines Tiefpassfilters auf 100 kHz bzw. 400 kHz beschränkt ist. Dies dient dazu während des späteren Betriebs des IC hochfrequente Störsignale auf dem Datenbus, die beispielsweise bei Verwendung des IC in Fernsehgeräten auftreten können, auszufiltern.

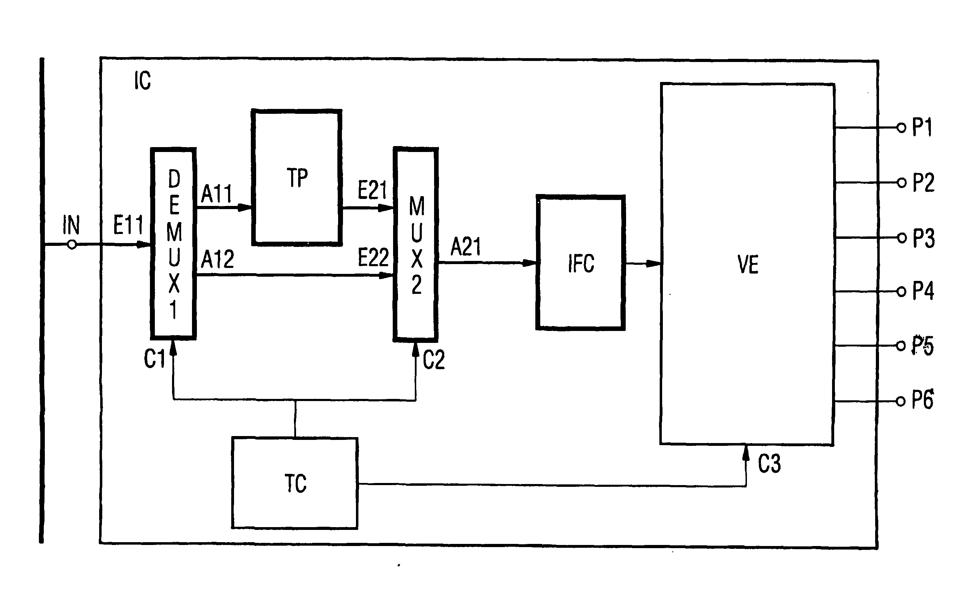

Ein zum Anschließen an einen IIC-Bus geeigneter, integrierter Baustein ist beispielsweise der PCF8577C der Firma Philips Semiconductors, Eindhoven, der in Philips: "PCF8577C Data Sheet: LCD direct/duplex driver with I²C-Bus interface", Eindhoven, Niederlande, 30. Juli 1998, Seiten 1 bis 28 beschrieben ist. Figur 1 dieses Datenblatts zeigt ein Blockschaltbild dieses integrierten Bausteins, der ein Eingangsfilter aufweist, das Eingängen zum Anschließen an den IIC-Bus nachgeschaltet ist.

Ziel der vorliegenden Erfindung ist es, einen integrierten Halbleiterbaustein zur Verfügung zu stellen, der ein schnelles Testen bei geringem zusätzlichen Schaltungsaufwand ermöglicht. Dieses Ziel wird durch einen integrierten Halbleiterbaustein gemäß den Merkmalen des Anspruchs 1 gelöst.

Vorteilhafte Ausgestaltungen der Erfindung sind Gegenstand der Unteransprüche.

Der erfindungsgemäße Halbleiterbaustein weist neben einem Anschluss zum Anschließen an einen Datenbus und einem dem Anschluss nachgeschalteten Tiefpassfilter eine Überbrückungsschaltungsanordnung zur Überbrückung des Tiefpassfilters auf. Der Datenbus ist dabei vorzugsweise ein IIC-Bus. Bei überbrücktem Tiefpassfilter können dem Halbleiterbaustein zu Testzwecken Daten bei einer wesentlich höheren Taktrate als während des normalen Betriebs des IC zugeführt werden. Die Überbrückung des sonst zur Reduzierung der Störanfälligkeit vorhandenen Tiefpassfilters ist während des Tests unbedenklich, da der Test -anders als der spätere Betrieb des IC- in einer abgeschirmten Umgebung stattfinden kann. Durch die Überbrückung des Tiefpassfilters können die zu Testzwecken notwendigen Einstellungen und Initialisierungen aufgrund der hohen erreichbaren Datenrate innerhalb einer kurzen Zeitdauer vorgenommen werden, bzw. erforderliche Testmuster können dem Baustein mit hoher Taktrate zugeführt werden. Der Baustein kann dadurch in kurzer Zeit getestet werden.

Da als Anschluss für die Zuführung der Testmuster mit hohen Taktraten der ohnehin vorhandene Anschlusspin für den Datenbus verwendet wird, ist der zu Testzwecken erforderliche Schaltungsaufwand des erfindungsgemäßen IC gering.

Die Schaltungsanordnung zum Überbrücken des Tiefpassfilters weist vorzugsweise einen Demultiplexer und einen Multiplexer auf, wobei der Demultiplexer dem Tiefpassfilter vorgeschaltet ist und wobei der Multiplexer dem Tiefpassfilter nachgeschaltet ist. Ein Eingang des Demultiplexers ist dabei vorzugsweise an den Datenbus angeschlossen und ein erster Ausgang des Demultiplexers ist an einen Eingang des Tiefpassfilters angeschlossen. Ein Ausgang des Tiefpassfilters ist weiterhin an einen ersten Eingang des Multiplexers angeschlossen, wobei ein zweiter Eingang des Multiplexers zum Überbrücken des Tiefpassfilters an einen zweiten Ausgang des Demultiplexers angeschlossen ist.

Der Halbleiterbaustein weist vorzugsweise eine Controllerschaltung auf, die das Testen des Bausteins unterstützt. Die Controllerschaltung ordnet den Anschlusspins des IC während des Tests Funktionen zu, welche ausschließlich Testzwecken dienen und sich von den Funktionen während des normalen Betriebs unterscheiden. So können über die Anschlusspins während des Tests beispielsweise die Werte interner Register oder interne Taktsignale ausgegeben werden, um zu überprüfen, ob die jeweiligen Register oder Taktgeneratoren korrekt funktionieren. Eine solche Controllerschaltung zum Testen des Bausteins ist beispielsweise ein nach IEEE 1149.1 standardisierter TAP-Controller (TAP = Test Access Port).

Die Multiplexer und Demultiplexer sind gemäß einer Ausführungsform der Erfindung durch die Controllerschaltung ansteuerbar, um das Tiefpassfilter zu Testzwecken zu überbrücken.

Die vorliegende Erfindung wird nachfolgend anhand eines Ausführungsbeispiels in einer Figur näher erläutert. Die Figur zeigt ein Blockschaltbild eines erfindungsgemäßen integrierten Halbleiterbausteins.

Der Halbleiterbaustein weist einen Eingang IN auf, der an einen Datenbus BUS, vorzugsweise einen IIC-Bus angeschlossen ist. Anschlüsse (Anschlusspins) P1, P2, P3, P4, P5, P6 dienen zum Anschluss an externe Bauelemente, welche weitere integrierte Schaltungen sein können. An diesen Anschlusspins P1, P2, P3, P4, P5, P6 stehen Ausgangsgrößen, beispielsweise zur Ansteuerung der externen Bauelemente, oder Eingangsgrößen, die in dem integrierten Halbleiterbaustein IC verarbeitet werden, zur Verfügung. Zur Verarbeitung der Ein- und Ausgangsgrößen ist eine Verarbeitungseinheit VE vorhanden, die eine Vielzahl von Schaltungskomponenten aufweist.

Der integrierte Halbleiterbaustein weist weiterhin eine Schnittstellenschaltung IFC auf, welche an die Verarbeitungseinheit angeschlossen ist und welche den Datenaustausch zwischen der Verarbeitungseinheit VE und dem Bus steuert. Der Verarbeitungseinheit VE werden dabei über die Schnittstellenschaltung IFC Daten von dem Bus zugeführt werden, und über die Schnittstelleneinheit erfolgt die Ausgabe von Daten der Verarbeitungseinheit VE an den Bus. Die Schnittstellenschaltung IFC ist bei Verwendung eines IIC-Buses ein herkömmliches sogenanntes IIC-Interface.

Zwischen den Bus und die Schnittstellenschaltung IFC ist ein Tiefpassfilter TP geschaltet, welches die Datenrate zwischen dem Bus und der Schnittstelleneinheit IFC, bzw. der Verarbeitungseinheit VE begrenzt. Bei Verwendung eines IIC-Buses beträgt die maximale Datenrate 100 kHz oder 400 kHz. Durch diese Beschränkung der Datenrate wird verhindert, dass hochfrequente Störsignale, die in den Datenbus eingekoppelt sind, in die Verarbeitungseinheit VE gelangen und dort zu Fehlfunktionen führen.

Erfindungsgemäß weist die integrierte Halbleiterschaltung eine Schaltungsanordnung zum Überbrücken des Tiefpassfilters TP zu Testzwecken auf. Diese Schaltungsanordnung weist in dem Ausführungsbeispiel nach Figur 1 einen Demultiplexer DEMUX1 auf, der zwischen die den Eingang IN und das Tiefpassfilter TP geschaltet ist. Dazu ist ein Eingang E11 des ersten Demultiplexers DEMUX1 an den Eingang IN und ein erster Ausgang A11 des Demultiplexers MUX1 an das Tiefpassfilter angeschlossen. Die Schaltungsanordnung zum Kurzschließen weist weiterhin einen Multiplexer MUX2 auf, der zwischen das Tiefpassfilter TP und die Schnittstellenschaltung IFC geschaltet ist, wobei ein Eingang des Multiplexers MUX2 an einen Ausgang des Tiefpassfilters TP und wobei ein Ausgang A21 des Multiplexers an die Schnittstellenschaltung IFC angeschlossen ist. Um ein Überbrücken des Tiefpassfilters TP zu ermöglichen, ist ein zweiter Ausgang A12 des Demultiplexers DEMUX1 an einen zweiten Eingang E22 des Multiplexers MUX2 angeschlossen.

Der Demultiplexer DEMUX1 und der Multiplexer MUX2 werden angesteuert durch eine zum Testen des Bausteins IC vorhandene Controllerschaltung, die an Steuereingänge C1, C2 der Multiplexer angeschlossen ist. Während des normalen Betriebs des Halbleiterbausteins IC ist in dem Demultiplexer DEMUX1 der Eingang E11 mit dem ersten Ausgang A11 verbunden, um die Daten von dem Bus dem Tiefpassfilter zuzuführen, und der erste Eingang E21 des Multiplexers MUX2 ist an dessen Ausgang A21 angeschlossen, um die Ausgangsdaten des Tiefpassfilters TP der Schnittstellenschaltung IFC und damit der Verarbeitungseinheit zuzuführen.

Zum Testen des Bausteins IC werden die Multiplexer DEMUX1, MUX2 durch die Controllerschaltung TC derart angesteuert, dass die Daten von dem Bus über den zweiten Ausgang A12 des Demultiplexers DEMUX1 und den zweiten Eingang E22 des Multiplexers MUX2 ungefiltert an die Schnittstellenschaltung IFC, bzw. die Verarbeitungseinheit VE, gelangen.

Zum Testen des Bausteins ist es erforderlich, an dem Baustein alle oder möglichst viele Einstellungen bzw. Initialisierungen, die möglich sind, vorzunehmen. Durch Überbrücken des Tiefpassfilters TP können dem IC während des Testens die entsprechenden Steuerbefehle mit einer wesentlich höheren Taktfrequenz als während des normalen Betriebs zugeführt werden. Der Test des erfindungsgemäßen Bausteins kann dadurch in kurzer Zeit unter Verwendung des ohnehin vorhandenen Anschlusspins IN für den Datenbus durchgeführt werden.

Die Controllerschaltung TC zur Ansteuerung des Demultiplexers DEMUX1 und des Multiplexers MUX2 ist vorzugsweise ein sogenannter TAP-Controller (TAP = Test Access Port) gemäß IEEE 1149.1, der zum Testen des integrierten Halbleiterbausteins IC vorhanden ist. Der TAP-Controller unterstützt den Ablauf des Tests des integrierten Bausteins IC. Der TAP-Controller ist neben den Multiplexern DEMUX1, MUX2 auch an die Verarbeitungseinheit VE angeschlossen und ordnet den Anschlusspins P1, P2, P3, P4, P5, P6 während des Tests andere Funktionen als während des normalen Betriebs zu. So können beispielsweise während des Testens die Werte interner Register oder die Signale interner Taktgeneratoren über die Anschlusspins P1...P6 nach außen gegeben werden, um ein ordnungsgemäßes Funktionieren dieser Komponenten zu überprüfen.

Die erfindungsgemäße Schaltungsanordnung zum Überbrücken des Tiefpassfilters ermöglicht somit ein schnelles Testen des integrierten Halbleiterbausteins unter Verwendung des ohnehin vorhandenen Anschlusses IN des integrierten Bausteins für den Datenbus. Der Hardwareaufwand für die Schaltungsanordnung ist mit einem Demultiplexer und einem Multiplexer DEMUX1, MUX2 gering und leicht realisierbar. Zudem kann zur Ansteuerung des Demultiplexers DEMUX1 und des Multiplexers MUX2 der ohnehin zum Testen vorhandene TAP-Controller verwendet werden.

### Bezugszeichenliste

- A11, A12: Ausgänge des ersten Multiplexers
- A21: Ausgang des zweiten Multiplexers
- BUS: Bus
- C1: Steueranschluss des ersten Multiplexers
- C2: Steueranschluss des zweiten Multiplexers
- E11: erster Eingang des ersten Multiplexers
- E21, E22: Eingänge des zweiten Multiplexers
- IC: integrierter Halbleiterbaustein
- IFC: Schnittstellenschaltung
- IN: Eingang des IC
- DEMUX1: Demultiplexer
- MUX2: Multiplexer
- P1 - P6: Anschlusspins des IC
- TP: Tiefpassfilter
- VE: Verarbeitungseinheit

## Patentansprüche

1. Integrierter Halbleiterbaustein mit wenigstens einem Anschluss (IN) zum Anschließen an einen Datenbus (BUS) und einem dem Anschluss (IN) nachgeschalteten Tiefpassfilter (TP)zum Zuführen von Daten während eines normalen Betriebs,
**dadurch gekennzeichnet, dass**
eine Schaltungsanordnung (DEMUX1, MUX2) zum Überbrücken des Tiefpassfilters (TP) zu Testzwecken vorgesehen ist.

2. Integrierter Halbleiterbaustein nach Anspruch 1, bei dem der wenigstens eine Anschluss (IN) zum Anschließen an einen IIC-Bus ausgebildet ist.

3. Integrierter Halbleiterbaustein, nach Anspruch 1 oder 2 bei dem die Schaltungsanordnung zum Überbrücken des Tiefpassfilters die folgenden Merkmale aufweist :
- einen Demultiplexer (DEMUX1) mit einem Eingang (E11), der an den wenigstens einen Eingang (IN) angeschlossen ist, einem ersten Ausgang (A11), der an das Tiefpassfilter (TP) angeschlossen ist und mit einem zweiten Ausgang (A12) ;
- einen Multiplexer (MUX2) mit einem ersten Eingang (E21), der an das Tiefpassfilter (TP) angeschlossen ist, einem zweiten Eingang (E22), der an den zweiten Ausgang (A12) des Demultiplexers (DEMUX1) angeschlossen ist und mit einem Ausgang (A21).

4. Integrierter Halbleiterbaustein nach Anspruch 3, bei dem der Ausgang (A21) des Multiplexers (MUX2) an eine Schnittstellenschaltung (IFC) zur Weiterverarbeitung der über den Datenbus (BUS) empfangenen Daten oder zur Bereitstellung der über den Datenbus (BUS) zu sendenden Daten aufweist.

5. Integrierter Halbleiterbaustein nach einem der vorangehenden Ansprüche, der einen zu Testzwecken vorhandenen Controller (TC) aufweist, wobei der Controller (TC) an den Demultiplexer (DEMUX1) und den Multiplexer (MUX2) zu deren Ansteuerung angeschlossen ist.

## Claims

1. Integrated semiconductor module having at least one terminal (IN) for connection to a data bus (BUS) and a low-pass filter (TP) connected downstream of the terminal (IN) for supplying data during normal operation,
**characterized in that**
a circuit arrangement (DEMUX1, MUX2) is provided for bridging the low-pass filter (TP) for test purposes.

2. Integrated semiconductor module according to Claim 1, in which the at least one terminal (IN) is designed for connection to an IIC bus.

3. Integrated semiconductor module according to Claim 1 or 2, in which the circuit arrangement for bridging the low-pass filter has the following features:
- a demultiplexer (DEMUX1) having an input (E11), which is connected to the at least one input (IN), a first output (A11), which is connected to the low-pass filter (TP), and having a second output (A12) ;
- a multiplexer (MUX2) having a first input (E21), which is connected to the low-pass filter (TP), a second input (E22), which is connected to the second output (A12) of the demultiplexer (DEMUX1), and having an output (A21).

4. Integrated semiconductor module according to Claim 3, in which the output (A21) of the multiplexer (MUX2) is connected to an interface circuit (IFC) for further processing of the data received via the data bus (BUS) or for providing the data to be transmitted via the data bus (BUS).

5. Integrated semiconductor module according to one of the preceding claims, which has a controller (TC) present for test purposes, the controller (TC) being connected to the demultiplexer (DEMUX1) and the multiplexer (MUX2) for the driving thereof.

## Revendications

1. Circuit intégré semi-conducteur avec au moins une connexion (IN) pour le connecter à un bus de données (BUS) et un filtre passe-bas (TP) connecté en aval de la connexion (IN) pour injecter des données lors du fonctionnement normal
**caractérisé en qu'**
un élément de commutation (DEMUX1, MUX2) pour shunter le filtre passe-bas (TP) est prévu pour les besoins du test.

2. Circuit intégré semi-conducteur selon la revendication 1,
**caractérisé en ce que**
la connexion (IN) est conçue pour connecter le circuit à un bus IIC.

3. Circuit intégré semi-conducteur selon la revendication 1 ou 2,
**caractérisé en ce que**
le dispositif de commutation pour shunter le filtre passe-bas présente les caractéristiques suivantes :
- un démultiplexeur (DEMUX1) avec une entrée (E11) connectée à la/aux entrées (IN), une première sortie (A11) connectée au filtre passe-bas (TP), et une deuxième sortie (A12), et
- un multiplexeur (MUX2) avec une première entrée (E21) connectée au filtre passe-bas (TP), une deuxième entrée (E22) connectée à la deuxième sortie (A12) du démultiplexeur (DEMUX1), et une sortie (A21).

4. Circuit intégré semi-conducteur selon la revendication 3,
**caractérisé en ce que**
la sortie (A21) du multiplexeur (MUX2) est connectée à un élément d'interface (IFC) pour la poursuite du traitement des données reçues via le bus de données (BUS) ou la préparation des données à émettre via le bus de données (BUS).

5. Circuit intégré semi-conducteur selon une des revendications précédentes,
**caractérisé en ce qu'**
il possède pour les besoins du test, un élément de commande (TC) connecté au démultiplexeur (DEMUX1) et au multiplexeur (MUX2) pour les commander.
